# EUROPÄISCHE PATENTSCHRIFT

(11) **EP 2 982 018 B1**
(45) Veröffentlichungstag und Bekanntmachung des Hinweises auf die Patenterteilung: **02.06.2021**
(21) Anmeldenummer: 14714993.4
(22) Anmeldetag: 01.04.2014
(51) Int. Cl.: H02J 1/10, H02J 3/46, H02H 7/10, H02M 3/16

(54) **STROMVERSORGUNGSEINHEIT UND VERFAHREN ZUM PARALLELSCHALTEN MEHRERER STROMVERSORGUNGSEINHEITEN**
POWER SUPPLY UNIT AND METHOD FOR PARALLEL CONNECTION OF A PLURALITY OF POWER SUPPLY UNITS
UNITÉ D'ALIMENTATION EN COURANT ET PROCÉDÉ DE MONTAGE EN PARALLÈLE DE PLUSIEURS UNITÉS D'ALIMENTATION EN COURANT

(30) Priorität: 05.04.2013 DE 202013101455 U; 10.12.2013 DE 102013113800
(43) Veröffentlichungstag der Anmeldung: 10.02.2016
(73) Patentinhaber: Weidmüller Interface GmbH & Co. KG, 32758 Detmold (DE)
(72) Erfinder: SCHÜRMANN, Klaus, 32791 Lage (DE)
(74) Vertreter: Kleine, Hubertus
(86) Internationale Anmeldenummer: PCT/EP2014/056541
(87) Internationale Veröffentlichungsnummer: WO 2014/161861

(56) Entgegenhaltungen:
- EP-A1- 2 501 010
- DE-A1- 2 855 466
- DE-U1-202011 050 987
- US-A- 6 157 555
- US-A1- 2006 239 046
- US-A1- 2011 235 379

## Beschreibung

Die Erfindung betrifft eine Stromversorgungseinheit zum Umwandeln einer Eingangsspannung in eine Ausgangsspannung, insbesondere ein Schaltnetzteil. Die Erfindung betrifft weiterhin ein Verfahren zum ausgangsseitigen Parallelschalten mehrerer Stromversorgungseinheiten.

Stromversorgungseinheiten dienen der Stromversorgung von elektrischen und elektronischen Komponenten mit einer Spannung, die von der zur Verfügung stehenden Spannung, beispielsweise der Netzspannung abweicht. Aufgrund ihres kompakten Aufbaus und dem verlustarmen und damit energieeffizienten Betrieb werden Stromversorgungseinrichtungen häufig als Schaltnetzteile ausgebildet. Beim Schaltnetzteil wird eine Eingangswechselspannung, meist eine Netzspannung, in eine ausgangsseitige Gleichspannung umgewandelt. Die Ausgangsgleichspannung ist dabei üblicherweise stabilisiert, d.h., dass sie durch einen Regelkreis möglichst unabhängig von einer angeschlossenen Last auf einen möglichst konstanten Wert geregelt wird. Neben der Regelung auf eine möglichst konstante Ausgangsspannung ist dem Regelkreis typischerweise auch eine Strombegrenzung implementiert, durch die der gelieferte Ausgangsstrom auf einen vorgegebenen Wert beschränkt wird, indem beim Erreichen des maximalen Stromwerts die Ausgangsspannung abgeregelt wird, so dass der vorgegebene Maximalstromwert nicht überschritten wird.

Insbesondere beim Einsatz in industriellen Produktions- oder Prozessanlagen müssen Stromversorgungseinheiten zuverlässig und langlebig ausgelegt sein. Um eine Versorgung der Anlage bzw. von Komponenten der Anlage auch bei einem Ausfall einer Stromversorgungseinheit zu ermöglichen, werden Stromversorgungseinheiten vielfach redundant eingesetzt, in der Weise, das mehrere Stromversorgungseinheiten ausgangsseitig parallel geschaltet werden, wobei die Belastbarkeit der Stromversorgungseinheiten so gewählt ist, dass auch beim Ausfall einer der Stromversorgungseinheiten die verbleibenden die angeschlossene Last noch zuverlässig versorgen können. Eine ausgangsseitige Parallelschaltung von Stromversorgungseinheiten kann auch dann vorgenommen werden, wenn mit den Stromversorgungseinheiten eine Last versorgt werden soll, deren Strombedarf die maximale Stromlast einer einzelnen Stromversorgungseinheit übersteigt.

Bei derartigen Parallelschaltungen ist es wichtig, dass die Stromversorgungseinheiten möglichst gleichmäßig belastet werden. Dieses ist ohne zusätzliche Maßnahmen üblicherweise nicht gegeben, da selbst baugleiche Stromversorgungseinheiten mit nominell gleicher Ausgangsspannung in ihrer tatsächlichen Ausgangsspannung zumindest geringfügig differieren können, was unter Umständen stark voneinander abweichende Ausgangsströme der einzelnen Stromversorgungseinheiten zur Folge hat. Ohne eine zusätzliche Maßnahme übernimmt dann zumeist eine der Stromversorgungseinheiten die volle Last bis zu ihrem Maximalstrom, während die andere oder die anderen Stromversorgungseinheiten lediglich die verbleibende benötigte Last übernehmen. Die stark belastete Stromversorgungseinheit arbeitet dann dauerhaft an ihrer Leistungsgrenze, wodurch ihre Lebensdauer erheblich abnimmt.

Um eine Gleichbelastung mehrerer parallel geschalteter Stromversorgungseinheit zu erreichen, ist es bekannt, den Ausgangsstrom jeder Stromversorgungseinheit zu messen, und die Ausgangsspannung mit einer externen analogen Regelung in Abhängigkeit von den fließenden Ausgangsströmen jeweils so zu regeln, dass die Stromversorgungseinheiten denselben Stromanteil liefern.

Eine solche Analogschaltung, mit der beim Parallelschalten von Stromversorgungseinheiten eine Gleichverteilung der Belastung erreicht wird, ist beispielsweise aus der Druckschrift DE 28 55 466 A1 bekannt.

Auch die Druckschrift US 2011/0235379 A1 zeigt ein Verfahren zum ausgangsseitigen Parallelschalten von mindestens zwei Stromversorgungseinheiten. Zum Zusammenschalten der Stromversorgungseinheiten wird deren Schaltung zu Ausgangsspannungsregelung um eine stromgesteuerte Komponente ergänzt. Durch diese Komponente wird eine Korrektur anhand eines gemeinsamen Stromsignals vorgenommen, wobei dieses Signal einen analogen Wert bereitstellt, der einen mittleren Stromwert aller Stromversorgungseinheiten abbildet.

Die Stromversorgungseinheiten werden bei dieser analogen Lösung gleichmäßig belastet, der zusätzliche externe Regelkreis macht diese Lösung jedoch material- und damit kostenintensiv und führt zu einem erhöhten Installationsaufwand.

Die Druckschrift DE 20 2011 050 987 U1 beschreibt ein Parallelschalten von Stromversorgungseinheiten und Lasten, wobei sie sich jedoch nicht mit einem Ausgleichen der Belastung der Stromversorgungseinheiten auseinandersetzt. Es wird lediglich eine Stromüberwachungseinheit betrieben, um zu beurteilen, ob eine der Stromversorgungseinheiten defekt ist. Wird festgestellt, dass eine der Stromversorgungseinheiten nicht stabil in Betrieb ist, wird eine andere der Stromversorgungseinheiten gestartet.

Die Druckschrift EP 2 501 010 A1 betrifft ein Zusammenschalten von Stromversorgungsmodulen verschiedener Ausgangsleistung. Je nach geforderter Ausgangsleistung werden Auswahlregeln beschrieben, ob und welche Module parallelgeschaltet werden oder nicht. Wie und ob eine Ungleichbelastung der parallel geschalteten Stromversorgungseinheiten erreicht wird, ist nicht Gegenstand dieser Druckschrift.

Die Druckschrift US 6,157,555 A beschreibt ein Verfahren bei dem eine Mehrzahl von stromgeregelten Stromversorgungseinheiten parallelgeschaltet sind. Dabei sollen die parallel geschalteten Stromversorgungseinheit dynamisch im Hinblick auf den Ausgangsstrom so begrenzt werden, dass alle Stromversorgungseinheiten gemeinsam innerhalb eines vorgegebenen Bereichs für ihre Stromaufnahme liegen. Dazu werden gemäß dieser Druckschrift nicht einzelne Stromwerte gemessen, sondern es wird der maximal vorgebbare Strom für eine Stromversorgungseinheit anhand der zur Verfügung stehenden Leistung bestimmt und daraus ein von jeder Einheit zu liefernder Strom berechnet.

Es ist eine Aufgabe der vorliegenden Erfindung, eine Stromversorgungseinheit, insbesondere ein Schaltnetzteil, zur Verfügung zu stellen, bei der sich auf einfache Weise bei ausgangsseitiger Parallelschaltung mit einer anderen, insbesondere baugleichen Stromversorgungseinheit eine möglichst gleichmäßige Strombelastung erzielen lässt, ohne dass eine aufwendige externe zusätzliche Beschaltung erforderlich ist.

Diese Aufgabe wird gelöst mit einer Stromversorgungseinheit und einem Verfahren zum ausgangsseitigen Parallelschalten von Stromversorgungseinheiten mit den Merkmalen des jeweiligen unabhängigen Patentanspruchs. Vorteilhafte Ausgestaltungen und Weiterbildungen sind in den abhängigen Ansprüchen angegeben.

Die Erfindung wird nachfolgend anhand von Ausführungsbeispielen mithilfe von Figuren näher erläutert. Die Figuren zeigen:
- Fig. 1: ein schematisches Blockschaltdiagramm mit mehreren ausgangsseitig parallelgeschalteten Stromversorgungseinheiten in einem ersten Ausführungsbeispiel;
- Fig. 2: eine beispielhafte Darstellung eines Schaltschranks mit einer Mehrzahl von Stromversorgungseinheiten in einem zweiten Ausführungsbeispiel und
- Fig. 3: ein schematisches Blockschaltbild einer Stromversorgungseinheit in dem zweiten Ausführungsbeispiel.

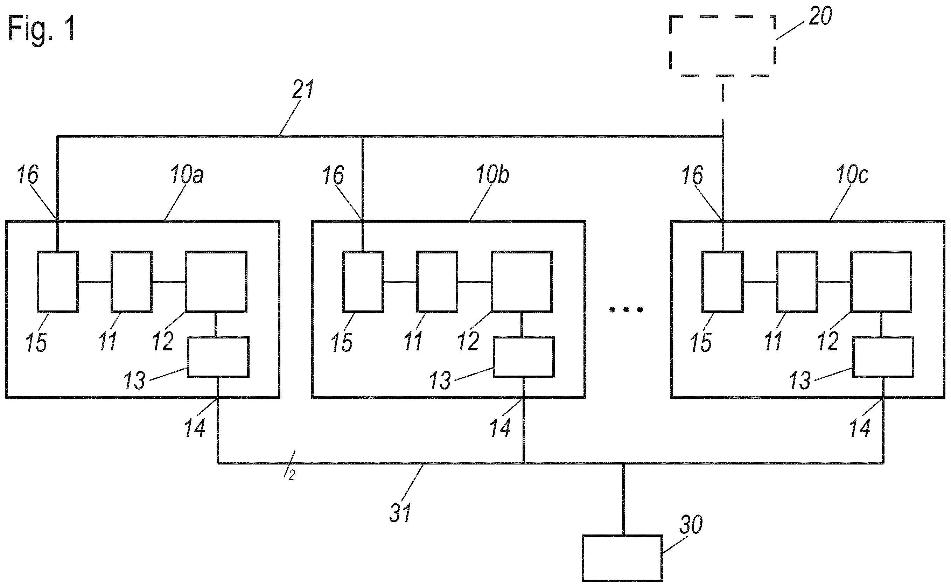

Fig. 1 zeigt in einem schematischen Blockschaltbild eine Anordnung mehrerer Stromversorgungseinheiten 10a, 10b und 10c, die ausgangsseitig parallel geschaltet sind.

Die einzelnen Stromversorgungseinheiten sind bevorzugt baugleich ausgebildet und zur Lieferung eines nominellen Ausgangsstroms (Nennstrom) der jeweils gleichen Größe. Wie nachfolgend ausgeführt wird, ist das erfindungsgemäße Verfahren jedoch auch zur Zusammenschaltung von Stromversorgungseinheiten mit unterschiedlichen Nennströmen geeignet.

Beispielhaft sind in der Fig. 1 drei Stromversorgungseinheiten 10a bis 10c dargestellt, wobei die Anzahl drei rein beispielhaft gewählt ist. Das Verfahren zum Parallelschalten von Stromversorgungseinheiten kann für eine beliebige Anzahl von mehr als zwei Stromversorgungseinheiten eingesetzt werden.

Jede der dargestellten Stromversorgungseinheiten 10a bis 10c ist beispielsweise als ein Schaltnetzteil ausgebildet, das eine eingangsseitig zugeführte (hier nicht dargestellte) Netzstrom in einen ausgangsseitigen Gleichstrom einer vorgegebenen Nennspannung, beispielsweise 24 Volt, umwandelt. Jede Stromversorgungseinheit 10a bis 10c weist dazu eine Steuerungseinheit 11 auf, die ein Leistungsteil 12 ansteuert, das der Umwandlung der Eingangsspannung in die Ausgangsspannung dient. Dem Leistungsteil 12 ist ein Modul 13 zur Verhinderung von Rückströmen zugeordnet, das einen in umgekehrter Richtung in das Leistungsteil 12 fließenden Strom verhindert. Im einfachsten Fall kann das Modul 13 durch eine Diode gebildet sein. Zur Verringerung von Verlusten ist es auch denkbar, einen aktiv in eine Richtung durchgeschalteten Transistor, insbesondere einen MOSFET-Transistor, einzusetzen. Die Ausgangsspannung bzw. der Ausgangsstrom wird an einem Ausgangsanschluss 14 bereitgestellt.

Die Stromversorgungseinheit 10a bis 10c sind über diesen Ausgangsanschluss 14 über Verbindungsleitungen 31 parallel geschaltet und versorgen gemeinsam eine an die Verbindungsleitungen 31 angeschlossene Last 30. Um eine gesicherte Versorgung der Last 30 auch dann gewährleisten zu können, wenn eines der Netzteile 10a bis 10c ausfällt, wird bevorzugt eine sogenannte (n+1)-Redundanz gewählt. Wenn zur Versorgung der Last 30 eine Anzahl von n Stromversorgungseinheiten benötigt wird, werden bevorzugt (n+1) Stromversorgungseinheiten eingesetzt. Benötigt die Last 30 beispielsweise einen Strom von 30 A (Ampere), so werden vorteilhafterweise vier Stromversorgungseinheiten 10a bis 10c eingesetzt, die jeweils für einen Nennstrom von 10 A ausgelegt sind.

Jede Stromversorgungseinheit 10a bis 10c weist weiterhin eine digitale Kommunikationsschnittstelle 15 auf, sowie ein Busschnittstelle 16. Die digitale Kommunikationsschnittstelle 15 kann beispielsweise gemäß der CAN-Spezifikation (Controller Area Network) ausgebildet sein. Die Stromversorgungseinheiten 10a bis 10c sind über eine Busleitung 21 jeweils miteinander über die Busschnittstelle 16 und die Kommunikationsschnittstelle 15 verbunden. Optional kann zusätzlich eine Verbindung zu einer übergeordneten Steuereinrichtung 20 ausgebildet sein.

Die Kommunikationsschnittstelle 15 ist mit der Steuereinrichtung 11 der Stromversorgungseinheit 10a bis 10c verbunden. Über die Kommunikationsschnittstelle 15 können gemessene Parameter der Stromversorgungseinheit 10a bis 10c bereitgestellt werden, die dann über die Busschnittstelle 16 abgerufen werden können. Diese Parameter können beispielsweise einen am Ausgang 14 gelieferten Strom I, eine am Ausgang 14 bereitgestellte Spannung U und eine relevante Temperatur der Stromversorgungseinheit 10a bis 10c betreffen.

Erfindungsgemäß ist die Stromversorgungseinheit 10a bis 10c zudem dazu eingerichtet, den an ihrem Ausgang 14 gelieferten Strom mit einem Stromwert zu vergleichen, den eines der anderen Stromversorgungseinrichtungen 10a bis 10c an ihrem jeweiligen Ausgang 14 bereitgestellt und abhängig von einem Ergebnis des Vergleichs die Spannung am Ausgang 14 zu verringern oder zu erhöhen. Zu diesem Zweck tauschen die Stromversorgungseinrichtungen 10a bis 10c über die Busleitung 21 die Größe des von ihnen jeweils bereitgestellten Ausgangsstroms I aus und passen die von ihnen bereitgestellte Spannung U am Ausgang 14 so an, das sich insgesamt möglichst eine Gleichverteilung der gelieferten Ströme I einstellt.

Dabei kann in einer Ausgestaltung des Verfahrens vorgesehen sein, das jede der Stromversorgungseinheiten 10a bis 10c aus der Höhe des von ihr selbst gelieferten Stroms I und den über die Busleitung 21 erhaltenen Stromwerte der anderen Stromversorgungseinheiten 10a bis 10c einen Strommittelwert bildet. Wenn der Strommittelwert größer ist als der von der betreffenden Stromversorgungseinheit 10a bis 10c gelieferte Strom I, erhöht diese Stromversorgungseinheit 10a bis 10c ihre Spannung U am Ausgang 14 um einen vorgegebenen Spannungsschritt, der beispielsweise im Bereich von einigen bis einigen zehn Millivolt liegen kann. Dabei kann ein Mindestzeitraum definiert sein, der zwischen zwei Spannungsanpassungen liegen muss, um eine unkontrollierte und sich ggf. zu einer Schwingung aufschaukelnde Spannungsänderung zu verhindern. Eine gewisse Wartezeit nach einer jeden Spannungsänderung ist auch im Hinblick auf die Datenübertragungsrate auf den Busleitungen 21 und die maximale Datenübertragungsrate der Kommunikationsschnittstellen 15 sinnvoll. Weiter kann vorgesehen sein, dass bei Über- oder Unterschreiten bestimmter vorgegebener Spannungsgrenzwerte eine Fehlermeldung ausgegeben wird, da eine zu sehr von der Nennspannung am Ausgang 14 abweichende Spannung auf einen Fehler innerhalb des Gesamtsystems schließen lässt.

Es versteht sich, das neben dem beschriebenen Verfahren, bei dem eine Spannungsänderung aus einem Vergleich mit einem Strommittelwert erfolgt, auch andere Verfahren zur Erzielung einer Gleichverteilung der Ausgangsströme eingesetzt werden können. Beispielsweise kann vorgesehen sein, dass jeweils die Stromversorgungseinheit 10a bis 10c, die den höchsten (niedrigsten) Stromwert I zum Gesamtstrom beiträgt, jeweils ihre Ausgangsspannung verringert (erhöht).

In einer anderen Ausgestaltung ist es denkbar, dass die Stromwerte der Stromversorgungseinheiten 10a bis 10c über die Busleitung 21 an die übergeordnete Steuereinrichtung 20 übertragen werden, die die Stromwerte dann untereinander vergleicht und ein Steuerkommando an die Stromversorgungseinheiten 10a bis 10c ausgibt, wobei das Steuerkommando eine Absenkung bzw. Erhöhung der Ausgangsspannung U der jeweiligen Stromversorgungseinheit 10a bis 10c zur Folge hat.

Insbesondere in einer Umsetzung, bei der eine Ansteuerung zum Ausgleich der Ausgangsströme über die externe Steuereinrichtung 20 vorgenommen wird, kann zusätzlich eine Funktionskontrolle der verschiedenen Netzteile 10a bis 10c ausgeführt werden, beispielsweise in regelmäßigen Zeitabständen, z.B. stündlich oder einmal am Tag. Beispielsweise kann vorgesehen sein, die bereitgestellte Ausgangsspannung am Ausgang 14 einer der Stromversorgungseinheiten 10a bis 10c auf null bzw. einen deutlich unterhalb der Nennspannung liegenden Wert herunterzufahren, und dann einen am Ausgang 14 dieser Stromversorgungseinheit 10a bis 10c fließenden Strom zu messen. Wird hier ein Stromfluss, ggf. ein rückwärtiger Stromfluss gemessen, deutet dieses auf einen Defekt in dem Modul 13 dieser Stromversorgungseinrichtung hin. Eine solche Überprüfung kann zyklisch bei allen Stromversorgungseinheiten 10a bis 10c durchgeführt werden, ohne dass dieses den Betrieb der Anlage unterbricht, da insbesondere bei einem System mit einer (n+1 )-Redundanz während der Zeit des Tests die verbleibenden Stromversorgungseinheiten die Versorgung der Last 30 übernehmen.

Bei der bisherigen Beschreibung des Ausführungsbeispiels der Fig. 1 wurde als eine Gleichbelastung der Stromversorgungseinheiten 10a bis 10c jeweils die Lieferung eines in seiner absoluten Höhe gleichen Stroms verstanden. Es ist jedoch auch möglich, die Gleichbelastung der Stromversorgungseinheiten 10a bis 10c prozentual gemessen an ihrem Nennstrom durchzuführen. In einer solchen Ausgestaltung können problemlos Stromversorgungseinheiten 10a bis 10c mit unterschiedlichen Nennströmen miteinander gekoppelt werden. Eine Stromversorgungseinheit mit einer doppelten Nennstrombelastung liefert dann auch den doppelten Anteil am Gesamtstrom bei gleicher prozentualer Belastung.

Besonders vorteilhaft kann das erfindungsgemäße Verfahren zum ausgangsseitigen Parallelschalten von Stromversorgungseinheiten dann eingesetzt werden, wenn Stromversorgungseinheiten innerhalb eines Anlagensystems verwendet werden, bei dem Kommunikationsschnittstellen an unterschiedlichsten Anlagenkomponenten zu Überwachungs- und Diagnosezwecken vorgesehen sind.

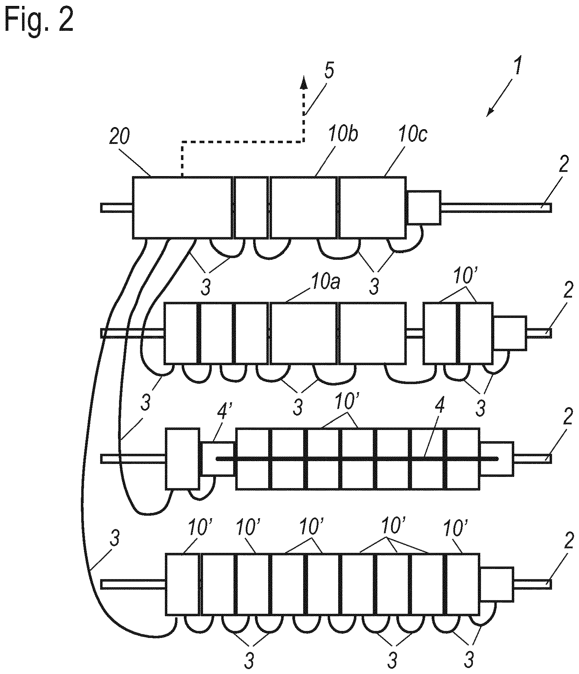

Fig. 2 zeigt dazu einen beispielhaften Aufbau eines Schaltschranks 1, bei dem eine Mehrzahl von Funktionselektronikmodulen auf verschiedenen Tragschienen 2 angeordnet ist. Von den Funktionselektronikmodulen sind der Übersichtlichkeit halber nur einige mit Bezugszeichen versehen. Unter den Funktionselektronikmodulen sind erfindungsgemäßen Stromversorgungseinheiten 10a bis 10c sowie weitere Funktionselektronikmodule 10', die beispielsweise Signalkonverter, Überspannungsmodule oder Überstromsicherungen sein können, wobei diese Aufzählung rein beispielhaft und nicht abschließend ist. Aus Gründen der Übersichtlichkeit sind Strom führende Kabel, die zu den Funktionselektronikmodulen und insbesondere zu den Stromversorgungseinheiten 10a bis 10c hin- oder wegführen, nicht dargestellt.

Die Funktionselektronikmodule und unter ihnen die Stromversorgungseinheiten 10a bis 10c sind jeweils über einen lokalen Bus 3 untereinander und mit einem Gateway 20, das ebenfalls auf einer der Tragschienen 2 angeordnet ist, verbunden. Der lokale Bus 3 ist vorliegend als drahtgebundener Bus von einem zum jeweils benachbarten Funktionselektronikmodul und schließlich zu einem von mehreren Anschlüssen an dem Gateway 20 geschleift.

Grundsätzlich sind hier auch andere Übertragungswege für den lokalen Bus möglich. Ein Beispiel ist bei der zweiten Tragschiene 2 von unten dargestellt. Bei dieser Tragschiene 2 wird der drahtgebundene lokale Bus 3 durch eine Einspeiseeinheit 4' auf entsprechende Busleitungen 4 in der Tragschiene 2 gekoppelt. Vorteilhafterweise kann neben den dargestellten Busleitungen 4 auch eine Stromversorgung für die Funktionselektronikmodule über entsprechende in der Tragschiene 2 angeordnete Leitungen bzw. Leiterbahnen erfolgen.

Die Funktionselektronikmodule sind jeweils mit einem Kommunikationsmodul ausgerüstet, das über eine Kommunikationsschnittstelle mit dem lokalen Bus 3 verbunden ist. Über das Kommunikationsmodul und die Kommunikationsschnittstelle können Informationen von den Funktionselektronikmodulen zu dem Gateway 20 übertragen werden. Das Gateway 20 überträgt diese Informationen auf eine weitere Kommunikationsschnittstelle, die über eine Netzwerkleitung 5, bevorzugt eine Ethernet-Leitung, mit einem als Verteiler arbeitenden Netzwerk-Switch 6 verbunden ist. Der Switch 6 ist dann über eine weitere Netzwerkleitung 5 mit einem übergeordneten Datennetzwerk verbunden.

Von den Funktionselektronikmodulen abgegebene Informationen werden so mit geringem zusätzlichem Aufwand in dem übergeordneten Datennetzwerk zur Auswertung und/oder Protokollierung und/oder Überwachung verfügbar. Dieses ist möglich, ohne dass grundlegende Änderungen an der Verdrahtung, dem Aufbau und auch der Betriebsweise des Schaltschranks 1 notwendig wären. Insbesondere arbeitet der Schaltschrank 1 nach wie vor autark und ist nicht von dem Vorhandensein und der korrekten Funktion einer übergeordneten Steuereinrichtung, beispielsweise einer Automatisierungssteuerung, abhängig.

Innerhalb eines solchen Systems lässt sich das erfindungsgemäße System zum Ausgleichen des Stroms bei einer Parallelschaltung der Stromversorgungseinheiten 10a bis 10c auf einfache Weise über den lokalen Bus 3 umsetzen. Der lokale Bus 3 entspricht damit der Busleitung 21 aus dem Ausführungsbeispiel der Fig. 1. Wie im Zusammenhang mit Fig. 1 erläutert, kann das erfindungsgemäße Verfahren innerhalb der StromversorgungseinheitenlOa bis 10c bei einem Datenaustausch der Stromversorgungseinheiten 10a bis 10c untereinander erfolgen. Es kann allerdings auch vorgesehen sein, dass das Gateway 20 als übergeordnete Steuereinrichtung 20 gemäß Fig. 1 fungiert und die von den einzelnen Stromversorgungseinheiten 10a bis 10c gelieferten Ströme einliest, untereinander vergleicht und Steueranweisungen an die Stromversorgungseinheiten 10a bis 10c ausgibt, um eine Gleichverteilung der Ausgangströme I zu erzielen.

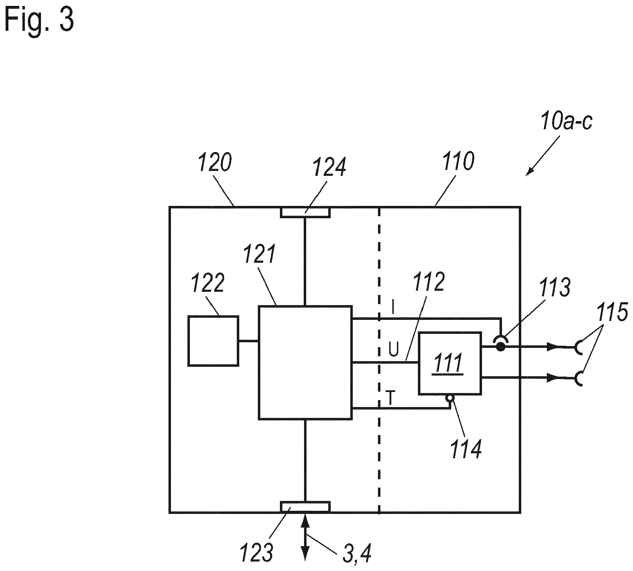

Fig. 3 zeigt den Aufbau einer Stromversorgungseinheit 10a bis 10c aus Fig. 2 in Form eines Blockschaltbildes detaillierter.

Die Stromversorgungseinheit 10a bis 10c lässt sich in zwei Einheiten unterteilen, eine Funktionseinheit 110 und ein Kommunikationsmodul 120. Vorliegend weist die Funktionseinheit 110 die Steuerung, den Leistungsteil und das Modul zur Verhinderung von Rückströmen auf, die nachfolgend zusammenfassend als Netzteil 111 bezeichnet werden. Das Netzteil 111 entspricht damit den Komponenten mit den Bezugszeichen 11 bis 13 aus dem ersten Ausführungsbeispiel. Das Netzteil weist zwei Ausgänge 115 zur Abgabe der Ausgangsspannung U bzw. des Ausgangsstroms I auf.

Das Kommunikationsmodul 120 weist eine Kommunikationsschnittstelle 123 auf, über die Informationen mit einem Gateway 20 (vgl. Fig. 2) ausgetauscht werden können. Die Kommunikationsschnittstelle 123 ist in verschiedenen Ausgestaltungen vorgesehen. Die Kommunikationsschnittstelle 123 kann insbesondere als busfähige Schnittstelle ausgebildet, beispielsweise in Form eines CAN-Busses, zur Verbindung mit einem extern geführten lokalen Bus 3,4 und damit zu einem Gateway 20, wie es in dem Ausführungsbeispiel der Fig. 2 dargestellt ist. Die digitale Übertragungsstrecke 113 ist darüber hinaus mit einem Eingang eines Mikrokontrollers 121 innerhalb des Kommunikationsmoduls 120 verbunden. Das Kommunikationsmodul 120 umfasst zudem einen Mikrokontroller 121, der dazu eingerichtet, die Parameter des Netzteils 111 zu erfassen, aufzuarbeiten, ggf. auszuwerten und zwischen zu speichern. Zu letzterem Zweck ist mit dem Mikrokontroller 121 ein optionaler externer Speicher 122 verbunden. Zudem können über die Kommunikationsschnittstelle 123 Steueranweisungen zur Steuerung des Netzteils 111 entgegengenommen werden.

Weiterhin ist eine Wartungsschnittstelle 124, auch Service-Schnittstelle 124 genannt, optional am Kommunikationsmodul 120 vorgesehen. Über die Service-Schnittstelle 124 kann insbesondere eine Einstellung interner Einstellungen des Mikrokontrollers 121 bzw. der von ihm ausgeführten Programme sowie eine Aktualisierung (Update) dieser Programme erfolgen. Die Service-Schnittstelle 124 kann beispielsweise als USB-Schnittstelle ausgebildet sein, an die ein Laptop eines Servicetechnikers vor Ort am Schaltschrank 1 angeschlossen werden kann.

Das Netzteil 111 weist einen Spannungsausgang 112 auf, der mit einem Analogeingang des Mikrokontrollers 121 verbunden ist. Über den Spannungsausgang 112 kann die an den Ausgängen 115 anliegende Ausgangspannung U gemessen werden. Zudem ist ein Strommesssensor 113 in der Funktionseinheit 110 vorgesehen, der der Bestimmung eines Ausgangsstroms I an dem Ausgang 115 dient und der ebenfalls mit einem Analogeingang des Mikrokontrollers 121 verbunden ist. Der Strommesssensor 113 kann z.B. durch einen Hallsensor oder einen Shunt realisiert sein. Weiterhin ist an dem Netzteil 111 ein Temperatursensor 114 angeordnet, der ebenfalls von dem Mikrokontroller 121 ausgelesen wird. Der Temperatursensor 114 dient der Ermittlung einer Betriebstemperatur T des Netzteils 111 und steht bevorzugt mit einem Leistungshalbleiter bzw. mit einem damit verbundenen Kühlkörper und/oder (Bulk-) Elektrolytkondensatoren des Netzteils 111 in thermischen Kontakt.

Über die erste Schnittstelle 123 können die so bestimmten Betriebsparameter, die Ausgangspannung U, der Ausgangsstrom I und die Betriebstemperatur T des Netzteils 111, von dem Gateway 20 eingelesen und entsprechend in dem übergeordneten Datennetz, mit dem das Gateway 20 verbunden ist, eingesehen werden. Zudem kann vorgesehen sein, anhand dieser Betriebsparameter einen aktuellen Belastungszustand des Netzteils 111 zu berechnen und die erwartete Lebensdauer des Netzteils 111 und damit der Stromversorgungseinheit zu ermitteln. Der Einfluss der Betriebsparameter auf die Lebensdauer kann dabei in Form von empirischen Daten, die individuell für diesen Typ von Stromversorgungseinheit gewonnen wurden, im Speicher 122 des Kommunikationsmoduls 120 hinterlegt sein.

Weiterhin können die über die Schnittstelle 123 ausgetauschten Betriebsparameter, insbesondere der Ausgangsstrom I, verwendet werden, um das erfindungsgemäße Verfahren zur Gleichverteilung des Ausgangsstroms umzusetzen. Falls der dabei erfolgende Vergleich der Ströme unterschiedlicher Stromversorgungseinheiten 10a bis 10c von dem Gateway 20 als externe Steuereinrichtung durchgeführt wird, kann die erste Schnittstelle 123 zudem verwendet werden, um Kommandos zur Abänderung der Ausgangsspannung U entgegenzunehmen.

### Bezugszeichenliste

- 1: Schaltschrank
- 2: Tragschiene
- 3: Bus
- 4: Busleitung
- 5: Netzwerkleitung
- 6: Switch

- 10': Funktionselektronikmodul

- 10a-c: Stromversorgungseinheit
- 11: Steuerungseinheit
- 12: Leistungsteil
- 13: Modul
- 14: Ausgangsanschluss
- 15: Kommunikationsschnittstelle
- 16: Busschnittstelle

- 20: Steuereinrichtung / Gateway
- 21: Busleitung

- 30: Last
- 31: Verbindungsleitung

- 110: Funktionseinheit
- 115: Ausgang
- 111: Netzteil
- 112: Ausgangsspannung/ Spannungsausgang
- 113: Strommesssensor
- 114: Temperatursensor

- 120: Kommunikationsmodul
- 121: Mikrokontroller
- 122: Speicher
- 123: Kommunikationsschnittstelle
- 124: Service-Schnittstelle

- I: Strom
- T: Betriebstemperatur
- U: Ausgangsspannung

## Patentansprüche

1. Verfahren zum ausgangsseitigen Parallelschalten von mindestens zwei Stromversorgungseinheiten (10a - 10c), mit den folgenden Schritten:
- Erfassen jeweils eines Ausgangsstroms (I) der mindestens zwei Stromversorgungseinheiten (10a - 10c);
- Übertragen der erfassten Ausgangsstromwerte über eine Kommunikationsschnittstelle (16, 123) der Stromversorgungseinheiten (10a - 10c);
- Vergleichen der erfassten Ausgangsstromwerte;
**gekennzeichnet durch** die folgenden weiteren Schritte:
- Abändern mindestens einer Ausgangsspannung (U) mindestens einer der Stromversorgungseinheiten (10a - 10c) um einen vorgegebenen Spannungsschritt, der einige bis einige zehn Millivolt beträgt, abhängig von einem Ergebnis des Vergleichs der erfassten Ausgangsstromwerte, falls der Vergleich eine Ungleichbelastung der Stromversorgungseinheiten (10a - 10c) anzeigt.

2. Verfahren nach Anspruch 1, bei dem der Schritte des Vergleichens der erfassten Ausgangsstromwerte innerhalb eines jeden der parallel geschalteten Stromversorgungseinheiten (10a - 10c) erfolgt.

3. Verfahren nach Anspruch 1, bei dem der Schritte des Vergleichens der erfassten Ausgangsstromwerte innerhalb einer mit den Stromversorgungseinheiten (10a - 10c) über deren Kommunikationsschnittstellen (16, 123) verbundenen übergeordneten Steuereinrichtung (20) erfolgt.

4. Verfahren nach einem der Ansprüche 1 bis 3, bei dem die erfassten Ausgangsstromwerte über die Kommunikationsschnittstelle (16, 123) und über einen die Stromversorgungseinheiten (10a - 10c) verbindenden Bus (3, 4, 21) übertragen werden.

5. Verfahren nach einem der Ansprüche 1 bis 4, bei dem nach einer erfolgten Änderung einer Ausgangsspannung (U) eine Mindestwartezeit eingehalten wird, bevor die Ausgangsspannung (U) erneut geändert werden kann.

6. Verfahren nach einem der Ansprüche 1 bis 5, bei dem ein von einer Stromversorgungseinheiten (10a - 10c) gelieferte Strom mit einem Mittelwert des von allen parallel geschalteten Stromversorgungseinheiten (10a - 10c) gelieferten Stroms verglichen wird.

7. Stromversorgungseinheit (10a - 10c) zur Bereitstellung eines Ausgangsstroms (I) bei einer Ausgangsspannung (U), aufweisend eine Kommunikationsschnittstelle (16, 123), die dazu eingerichtet ist, eine Höhe eines von ihr gelieferten Stroms (I) zu übertragen und mindestens einen von einer weiteren Stromversorgungseinheit bereitgestellten Stromwert einzulesen, **dadurch gekennzeichnet, dass**
die Stromversorgungseinheit (10a - 10c) dazu eingerichtet ist, die Ausgangsspannung (U) in Abhängigkeit eines Ergebnisses eines Vergleichs der Höhe des von ihr gelieferten Stroms (I) mit dem mindestens einen eingelesenen Stromwert um Spannungsschritte vorgegebener Höhe, von denen jeder einige bis einige zehn Millivolt beträgt, abzuändern.

## Claims

1. Method for connecting at least two power supply units (10a-10c) in parallel on the output side, comprising the following steps:
- detecting in each case an output current (I) of the at least two power supply units (10a-10c);
- transmitting the detected output current values via a communication interface (16, 123) of the power supply units (10a-10c);
- comparing the detected output current values;
**characterized by** the following further steps:
- modifying at least one output voltage (U) of at least one of the power supply units (10a-10c) by a predetermined voltage step, which is a few to a few tens of millivolts, depending on a result of the comparison of the detected output current values, if the comparison indicates an unequal load of the power supply units (10a-10c).

2. Method according to claim 1, wherein the steps of comparing the detected output current values are performed within each of the power supply units (10a-10c) connected in parallel.

3. Method according to claim 1, wherein the steps of comparing the detected output current values are performed within a higher-level control device (20) connected to the power supply units (10a-10c) via their communication interfaces (16, 123).

4. Method according to one of claims 1 to 3, wherein the detected output current values are transmitted via the communication interface (16, 123) and via a bus (3, 4, 21) connecting the power supply units (10a-10c).

5. Method according to one of claims 1 to 4, wherein, after an output voltage (U) has been changed, a minimum waiting time is observed before the output voltage (U) can be changed again.

6. Method according to one of claims 1 to 5, wherein a current supplied by one power supply unit (10a-10c) is compared with an average value of the current supplied by all power supply units (10a-10c) connected in parallel.

7. Power supply unit (10a-10c) for providing an output current (I) at an output voltage (U), comprising a communication interface (16, 123) which is set up to transmit a level of a current (I) which it supplies and to read in at least one current value which is provided by a further power supply unit,
**characterized in that** the power supply unit (10a-10c) is adapted to vary the output voltage (U) by voltage steps of predetermined level, each of which is a few to a few tens of millivolts, depending on a result of a comparison of the level of the current (I) supplied by it with the at least one current value that is read in.

## Revendications

1. Procédé pour le montage parallèle en sortie d'au moins deux unités d'alimentation électrique (10a - 10c), comprenant les étapes suivantes :
- détection d'une intensité de sortie (I) de chacune des au moins deux unités d'alimentation électrique (10a- 10c) ;
- transmission des valeurs d'intensité de sortie détectées via une interface de communication (16, 123) des unités d'alimentation électrique (10a - 10c) ;
- comparaison des valeurs d'intensité de sortie détectées ;
**caractérisé en ce qu'**il comprend les étapes suivantes :
- modification d'au moins une tension de sortie (U) d'au moins une des unités d'alimentation électrique (10a - 10c) d'un cran de tension prédéterminé de quelques millivolts à quelques dizaines de millivolts, en fonction d'un résultat de la comparaison des valeurs d'intensité de sortie détectées, si la comparaison indique un déséquilibre de charge entre les unités d'alimentation électrique (10a-10c).

2. Procédé selon la revendication 1, dans lequel l'étape de comparaison des valeurs d'intensité de sortie détectées est exécutée dans chacune des unités d'alimentation électrique (10a - 10c) montées en parallèle.

3. Procédé selon la revendication 1, dans lequel l'étape de comparaison des valeurs d'intensité de sortie détectées est exécutée dans un dispositif de commande d'ordre supérieur (20) relié aux unités d'alimentation électrique (10a - 10c) via leurs interfaces de communication (16, 123).

4. Procédé selon l'une des revendications 1 à 3, dans lequel les valeurs d'intensité de sortie détectées sont transmises via l'interface de communication (16, 123) et via un bus (3, 4, 21) reliant les unités d'alimentation électrique (10a-10c).

5. Procédé selon l'une des revendications 1 à 4, dans lequel, après une modification d'une tension de sortie (U), un temps d'attente minimal est respecté avant que la tension de sortie (U) puisse être modifiée à nouveau.

6. Procédé selon l'une des revendications 1 à 5, dans lequel une intensité fournie par une unité d'alimentation électrique (10a - 10c) est comparée à l'intensité fournie par toutes les unités d'alimentation électrique (10a - 10c) montées en parallèle.

7. Unité d'alimentation électrique (10a - 10c) pour la fourniture d'un intensité de sortie (I) sous une tension de sortie (U), présentant une interface de communication (16, 123) conçue pour transmettre une grandeur de l'intensité (I) qu'elle fournit et lire au moins une valeur d'intensité fournie par une autre unité d'alimentation électrique, **caractérisée en ce que** l'unité d'alimentation électrique (10a - 10c) est conçue pour modifier la tension de sortie (U) en fonction d'un résultat d'une comparaison de la grandeur de l'intensité (I) qu'elle fournit avec l'au moins une valeur d'intensité lue selon des crans de tension de grandeur prédéterminée dont chacun est de quelques millivolts à quelques dizaines de millivolts.
